# EUROPEAN PATENT APPLICATION

(11) **EP 1 143 614 A1**
(43) Date of publication of application: **10.10.2001**
(21) Application number: 00961074.2
(22) Date of filing: 19.09.2000
(51) Int. Cl.: H03H 9/25, H03H 3/08

(54) **SURFACE ACOUSTIC WAVE DEVICE AND METHOD OF PRODUCING THE SAME**

(30) Priority: 20.09.1999 JP 26636399
(71) Applicant: KABUSHIKI KAISHA TOSHIBA, Kawasaki-shi, Kanagawa-ken 210-8572 (JP)
(72) Inventor: Kobayashi, Reiko, Yokohama-shi Kanagawa 247-0026 (JP); Furukawa, Osamu, Sagamihara-shi Kanagawa 229-0026 (JP)
(74) Representative: HOFFMANN - EITLE
(86) International application number: JP0006374
(87) International publication number: WO0122580

(57) **Abstract**

A surface acoustic wave element constituted by forming a comb electrode and a terminal electrode on a piezoelectric element and a base substrate including an element connection terminal and an external connection terminal are opposed to each other, the terminal electrode and the element connection terminal are connected to each other, and the peripheries of the base substrate and the surface acoustic wave element are sealed with a sealing member and bonded to each other.

## Description

### Technical Field

This invention relates to a miniaturized surface acoustic wave device and a method for manufacturing the same.

### Background Art

In general, a surface acoustic wave device converts an electrical signal to a surface acoustic wave (SAW) and transmits/receives a signal using a thin-film metal comb electrode (IDT: Inter-Digital Transducer) formed on a piezoelectric element.

Such a surface acoustic wave device is used in a surface acoustic wave filter, a surface acoustic wave resonator, a delay circuit, or the like.

Recently, the surface acoustic wave device has been used widely in the field of a mobile communication system such as a cellular phone in particular because the device can be thinned and miniaturized.

At present, the surface acoustic wave device is required to be miniaturized further as a cellular phone decreases in size.

A surface acoustic wave device having a structure as disclosed in, e.g., Jpn. Pat. Appln. KOKAI Publication No. 8-191181 is known as a prior art one.

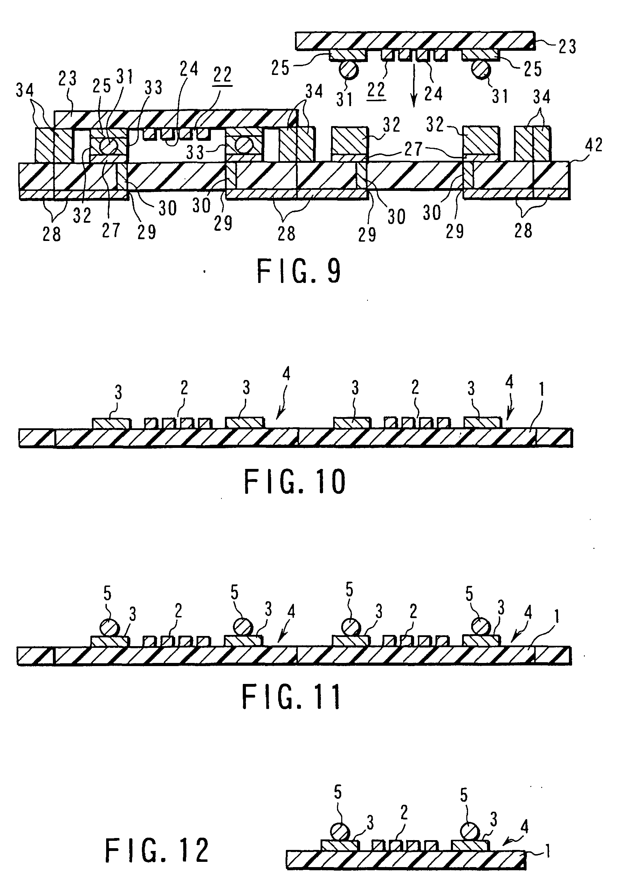

The surface acoustic wave device disclosed in Jpn. Pat. Appln. KOKAI Publication No. 8-191181 will now be described with reference to FIGS. 10 to 15 that show a manufacturing process thereof.

As shown in FIG. 10, comb electrodes 2 and terminal electrodes 3 are formed of a metal thin film such as aluminum (Al) on a piezoelectric substrate 1, thereby forming a plurality of surface acoustic wave elements 4, 4.

Then, a metal bump 5 is formed on each of the terminal electrodes 3, as illustrated in FIG. 11.

As shown in FIG. 12, the piezoelectric substrate 1 is cut into individual surface acoustic wave elements 4 by dicing or the like.

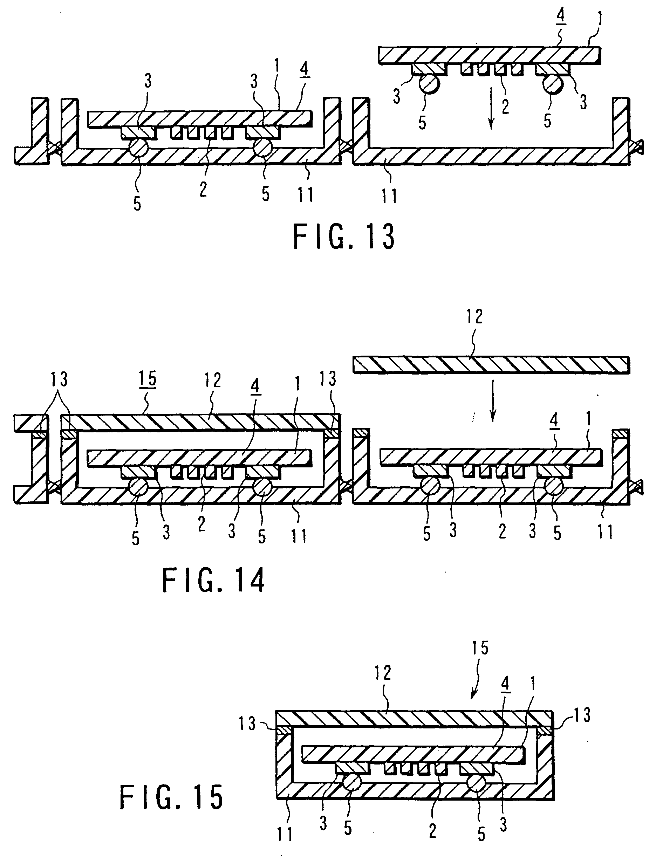

After that, the surface acoustic wave elements 4 are face-down-bonded by means of ultrasonic wave to their respective box-type ceramic packages 11 connected to each other, as shown in FIG. 13. Each of the packages 11 has an opening at the top and includes an external connection terminal and an element connection terminal in advance, neither of which is shown.

In this state, the opening of each package 11 is blocked with a cap 12, and the cap 12 is fixed to the package 11 by an adhesive 13, as shown in FIG. 14. Thus, the surface acoustic wave element 4 is sealed in a space formed between the package 11 and the cap 12.

The respective packages 11 are separated from each other to form a surface acoustic wave device 15, as illustrated in FIG. 15.

However, the prior art surface acoustic wave device shown in FIGS. 10 to 15 is so constituted that the surface acoustic wave element 4 is mounted in the package 11.

The problem therefore occurs in which the size of the package 11 has to be about four times as large as that of the surface acoustic wave element 4 from the viewpoint of the accuracy of mounting the surface acoustic wave element 4 in the package 11, the mechanism for holding the mounted element in the package, or the obtainment of space for mounting the cap 12 on the package 11.

Since, moreover, the cap 12 is mounted on the package 11 in order to seal the surface acoustic wave element 4, the mounting step is added and the material costs of the cap 12 are required, which becomes uneconomical.

Since, furthermore, the surface acoustic wave element 4 is face-down-bonded to the package 11 by means of ultrasonic wave or the like, there occurs an inconvenience of limiting the material of the package 11 or the piezoelectric substrate 1 to a hard material that does not absorb the ultrasonic wave.

Accordingly, the present invention has been developed in consideration of the above situation and its object is to provide a small-sized surface acoustic wave device that increases in productivity and reliability and a method for manufacturing the device.

### Disclosure of Invention

A surface acoustic wave device according to the present invention, comprises a base substrate having an external connection terminal and an element connection terminal electrically connected to the external connection terminal, a surface acoustic wave element arranged opposite to the base substrate and having a piezoelectric element, a comb electrode and a terminal electrode connected thereto being formed on an inner major surface of the piezoelectric element, a connection member for connecting the element connection terminal and the terminal electrode, and a frame-like resin member whose side continues with one side of the piezoelectric element and the base substrate, the frame-like resin member being sandwiched between an inner major surface of the base substrate and the inner major surface of the piezoelectric element, and holding and bonding the base substrate and the piezoelectric element with a predetermined gap therebetween.

A method for manufacturing a surface acoustic wave device according to the present invention, comprises a first step of forming a comb electrode and a terminal electrode electrically connected thereto on each of a plurality of piezoelectric elements into which a piezoelectric wafer is cut, thereby forming a plurality of surface acoustic wave elements, a second step of forming a metal bump on the terminal electrode of each of the surface acoustic wave elements, a third step of forming an external connection terminal and an element connection terminal electrically connected thereto on each of a plurality of base substrates into which a base plate is cut, a fourth step of applying a resin member to a frame-like periphery of each of the plurality of base substrates, a fifth step of facing the surface acoustic wave element and the base substrate each other such that the terminal electrode and the element connection terminal are connected to each other through the metal bump, and a sixth step of curing the resin member to bond the surface acoustic wave element and the base substrate to each other.

According to the above structure and method, the terminal electrode of the surface acoustic wave element and the element connection terminal of the base substrate are electrically connected through a metal bump, and the piezoelectric element and the base substrate are bonded by the frame-like resin member sandwiched therebetween. No clearance is therefore required between the surface acoustic wave element and the package wall surface. The device can be thinned and the package itself can be formed to have the same area as that of the surface acoustic wave element; consequently, the device can be miniaturized.

### Brief Description of Drawings

FIG. 1 is a sectional side view explaining one embodiment of a surface acoustic wave device according to the present invention;
FIG. 2 is a sectional side view explaining one step of a manufacturing method of the surface acoustic wave device according to the embodiment;
FIG. 3 is a sectional side view explaining a step subsequent to the step shown in FIG. 2 in the manufacturing method according to the embodiment;
FIG. 4 is a sectional side view explaining a step subsequent to the step shown in FIG. 3 in the manufacturing method according to the embodiment;
FIG. 5 is a sectional side view explaining a step subsequent to the step shown in FIG. 4 in the manufacturing method according to the embodiment;
FIG. 6 is a sectional side view explaining a step subsequent to the step shown in FIG. 5 in the manufacturing method according to the embodiment
FIG. 7 is a sectional side view explaining a step subsequent to the step shown in FIG. 6 in the manufacturing method according to the embodiment;
FIG. 8 is a sectional side view explaining a step subsequent to the step shown in FIG. 3 in a modification to the manufacturing method according to the embodiment;
FIG. 9 is a sectional side view explaining a step subsequent to the step shown in FIG. 5 in the manufacturing method according to the modification;
FIG. 10 is a sectional side view explaining one step of a manufacturing method of a prior art surface acoustic wave device;
FIG. 11 is a sectional side view explaining a step subsequent to the step shown in FIG. 10 in the prior art manufacturing method;
FIG. 12 is a sectional side view explaining a step subsequent to the step shown in FIG. 11 in the prior art manufacturing method;
FIG. 13 is a sectional side view explaining a step subsequent to the step shown in FIG. 12 in the prior art manufacturing method;
FIG. 14 is a sectional side view explaining a step subsequent to the step shown in FIG. 13 in the prior art manufacturing method; and
FIG. 15 is a sectional side view explaining a step subsequent to the step shown in FIG. 14 in the prior art manufacturing method.

### Best Mode for Carrying Out of the Invention

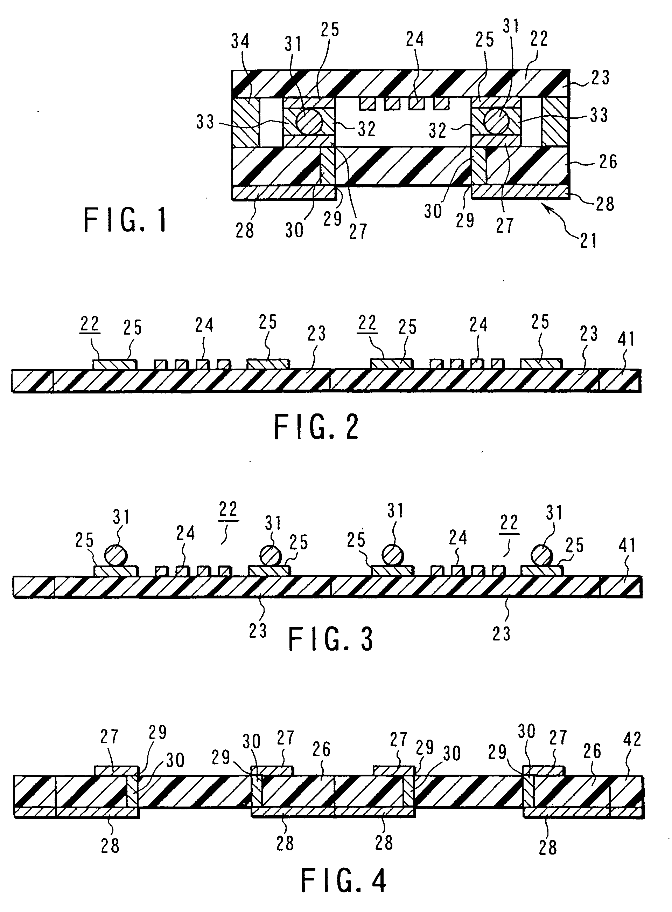

One embodiment of the present invention will be described in detail hereinafter with reference to the drawings. As FIG. 1 shows, a surface acoustic wave device 21 has a surface acoustic wave element 22.

In the surface acoustic wave element 22, a comb electrode 24 serving as an inter-digital transducer (IDT) and terminal electrodes 25, which are made of a metal thin film of aluminum (Al), are formed on one inner major surface of a plate-like piezoelectric element 23.

In FIG. 1, reference numeral 26 indicates a base substrate. The base substrate 26 is formed like a plate, the shape of which is substantially the same as that of the surface acoustic wave element 22 and the area of which is the same as that of the element 22.

An element connection terminal 27 is formed on one inner major surface of the base substrate 26. An external connection terminal 28 is formed on the other surface of the base substrate 26.

The base substrate 26 includes a contact hole 29 formed in a portion sandwiched between the element connection terminal 27 and the external connection terminal 28.

In the base substrate 26, the element connection terminal 27 and the external connection terminal 28 are electrically connected to each other via a connecting section 30 provided in the contact hole 29.

The surface acoustic wave element 22 is face-down-bonded to the base substrate 26 such that they face each other with a predetermined interval therebetween.

In this case, the element connection terminal 27 of the base substrate 26 and the terminal electrode 25 of the surface acoustic wave element 22 are arranged so as to face each other.

The element connection terminal 27 and the terminal electrode 25 are mechanically bonded and electrically connected to each other through a connection member 33. The connection member 33 includes a convex conductive metal bump 31 and a conductive adhesive 32.

A sealing member 34 is formed of a conductive adhesive and interposed between opposing peripheral portions of the base substrate 26 and the surface acoustic wave element 22.

The sealing member 34 is a frame-like resin member, and the resin member is sandwiched between the piezoelectric element 23 and the base substrate 26 such that its side surface continues with that of the piezoelectric element 23 or the base substrate 26. In this embodiment, the piezoelectric element 23, the side surface of the base substrate 26, and the resin member constitute a package wall surface.

The sealing member 34 allows the base substrate 26 and the surface acoustic wave element 22 to be mechanically bonded to each other with a predetermined interval therebetween.

The sealing member 34 has a function of sealing the periphery of the comb electrode 24 between the piezoelectric element 23 and the base substrate 26 and serves as a conductive path used for establishing a ground.

A method for manufacturing the surface acoustic wave device 21 described above will now be described with reference to FIGS. 2 to 7.

Referring first to FIG. 2, a comb electrode 24 and a terminal electrode 25 are formed of a metal thin film of aluminum (Al) or the like on a piezoelectric wafer 41 to form a plurality of surface acoustic wave elements 22, 22.

As FIG. 3 illustrates, a metal bump 31 is formed on the terminal electrode 25 of each surface acoustic wave element 22 by bonding, screen printing or the like.

As FIG. 4 shows, a contact hole 29 is formed in a given position of a base plate 42 in which a plurality of base substrates 26 are formed.

An element connection terminal 27 is formed on one surface of the base plate 42. An external connection terminal 28 is formed on the other surface of the base plate 42.

After that, a connecting section 30 is formed in the contact hole 29 to electrically connect the element connection terminal 27 and the external connection terminal 28 with each other.

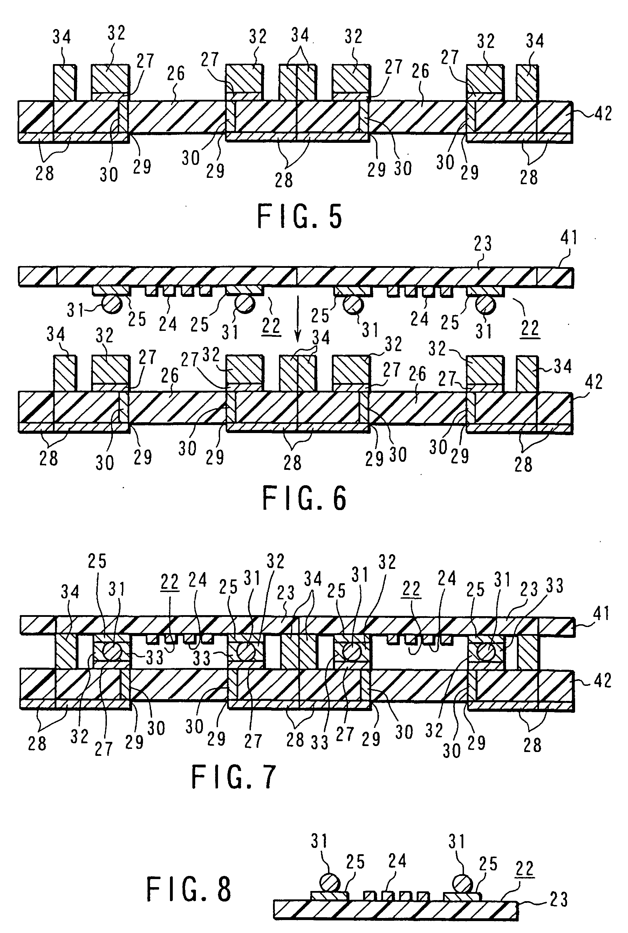

As shown in FIG. 5, a conductive adhesive 32 is applied to the element connection terminal 27 of each of the base substrates 26 of the base plate 42 in the applying step.

At the same time, a sealing member 34, which is formed of a conductive adhesive having the same material as that of the conductive adhesive 32, is applied to the periphery portion of each of the base substrates 26 of the base plate 42 by screen printing.

After that, as illustrated in FIG. 6, the surface acoustic wave element 22 of the piezoelectric wafer 41 is provided above and opposite to its corresponding one of the base substrates 26 of the base plate 42 in a mounting step.

In this case, the element connection terminal 27 of the base substrate 26 and the terminal electrode 25 of the surface acoustic wave element 22 are arranged so as to face each other.

As FIG. 7 shows, in a fixing step, the conductive adhesive 32 is cured by thermosetting to form a connection member 33 together with the metal bump 31. Thus, the element connection terminal 27 and the terminal electrode 25 are electrically connected to each other.

Simultaneously, the sealing member 34 is cured to bond the piezoelectric element 23 and the base substrate 26 to each other and seal the periphery of the comb electrode 24 therebetween.

Since the base substrate 26 and the surface acoustic wave element 22 have substantially the same shape as shown in FIG. 1, the piezoelectric wafer 41 and the base plate 42 are diced together and cut into individual base substrates 26 and surface acoustic wave elements 22. The surface acoustic wave device 21 is formed accordingly.

A modification to the above-described embodiment will now be described. The metal bump 31 is formed on the terminal electrode 25 of each of the surface acoustic wave elements 22 as shown in FIG. 3. Then, the surface acoustic wave elements 22 are separated from each other as illustrated in FIG. 8.

After the step shown in FIG. 5, each of the surface acoustic wave elements 22 can independently be connected to the base plate 42, as illustrated in FIG. 9. In this modification, the separation of the piezoelectric wafer 41 and that of the base plate 42 are performed in different steps.

In the foregoing embodiment, the sealing member 34 is made of the same material as that of the conductive adhesive 32 for connecting the element connection terminal 27 and the terminal electrode 25 and can be formed concurrently with the conductive adhesive 32. This reduces the number of steps and improves the operability.

However, the sealing member 34 need not always be made of the same material as that of the conductive adhesive 32. For example, an insulative adhesive can be used. In particular, the insulative adhesive has the advantage that it contains no conductive particles and its mechanical strength is greater than that of the conductive adhesive.

For example, a silver-epoxy material in which silver particles are scattered in epoxy resin can be used as the conductive adhesive.

Epoxy resin is favorable for insulative resin when a user places importance on resistance to moisture. Silicon resin and polyimide resin are also favorable for the insulative resin when a user places importance on elasticity to mitigate distortion due to the stress of thermal expansion of a substrate.

In the surface acoustic wave device 21 formed in the above-described embodiment, a protective film can cover the surface of the piezoelectric element 23 on which neither the comb electrode 24 nor the terminal electrode 25 is formed.

As the protective film, for example, copper, nickel, aluminum, silicon dioxide, epoxy resin, silicon resin can be employed.

If the protective film is formed in the stage before the piezoelectric element 23 is separated or in the stage where the element 23 has not been separated from one piezoelectric wafer 41, the operability is improved.

Since, moreover, the element connection terminal 27 of the base substrate 26 and the terminal electrode 25 of the surface acoustic wave element 22 are electrically connected to each other, the conductive adhesive 32 is not necessarily required.

The reason for the above is as follows: Adequate electrical connection can be achieved by sandwiching the metal bump 31 between the element connection terminal 27 and the terminal electrode 25 and crushing the metal bump 31 by pressure applied thereto.

In short, the mechanical coupling between the base substrate 26 and the surface acoustic wave element 22 is held firmly by the sealing member 34. The connection between the element connection terminal 27 and the terminal electrode 25 needs no great mechanical strength.

The above-described embodiment is directed to an example using a so-called single-layer wiring substrate in which the element connection terminal 27 is formed on one surface of the base substrate 26 and the external connection terminal 28 is formed on the other surface thereof.

However, the present invention is not limited to the single-layer wiring substrate. Using a multi-layer wiring substrate in which an insulation substrate and an electrode pattern are stacked in layers, the degree of freedom of wiring can be heightened further.

The present invention is not limited to the above embodiment. Various changes and modifications can be made without departing from the scope of the subject matter of the invention.

### Industrial Applicability

As described above in detail, according to the present invention, the terminal electrode of the surface acoustic wave element and the element connection terminal of the base substrate are electrically connected to each other by the connection member, and the piezoelectric element and the base substrate are bonded to each other by the frame-like resin member sandwiched therebetween. No clearance is therefore required between the surface acoustic wave element and the package wall surface. The surface acoustic wave device can be thinned and the package size can be set to the same as that of the surface acoustic wave element. The device can be miniaturized accordingly. Consequently, there is a high possibility that the device is used widely in the field of a mobile communication system such as a cellular phone.

## Claims

1. A surface acoustic wave device **characterized by** comprising:
a base substrate having an external connection terminal and an element connection terminal electrically connected to the external connection terminal;
a surface acoustic wave element arranged opposite to the base substrate and having a piezoelectric element, a comb electrode and a terminal electrode connected thereto being formed on an inner major surface of the piezoelectric element;
a connection member for connecting the element connection terminal and the terminal electrode; and
a frame-like resin member whose side continues with one side of the piezoelectric element and the base substrate, the frame-like resin member being sandwiched between an inner major surface of the base substrate and the inner major surface of the piezoelectric element, and holding and bonding the base substrate and the piezoelectric element with a predetermined gap therebetween.

2. The surface acoustic wave device according to claim 1, **characterized in that** the frame-like resin member is formed of a conductive adhesive.

3. The surface acoustic wave device according to claim 2, **characterized in that** the connection member is formed of a conductive adhesive.

4. The surface acoustic wave device according to claim 1, **characterized in that** the frame-like resin member is formed of an insulative adhesive.

5. The surface acoustic wave device according to claim 1, **characterized in that** the surface acoustic wave element and the base substrate are formed to have substantially the same outside shape.

6. A method for manufacturing a surface acoustic wave device, **characterized by** comprising:
a first step of forming a comb electrode and a terminal electrode electrically connected thereto on each of a plurality of piezoelectric elements into which a piezoelectric wafer is cut, thereby forming a plurality of surface acoustic wave elements;
a second step of forming a metal bump on the terminal electrode of each of the surface acoustic wave elements;
a third step of forming an external connection terminal and an element connection terminal electrically connected thereto on each of a plurality of base substrates into which a base plate is cut;
a fourth step of applying a resin member to a frame-like periphery of each of the plurality of base substrates;
a fifth step of facing the surface acoustic wave element and the base substrate each other such that the terminal electrode and the element connection terminal are connected to each other through the metal bump; and
a sixth step of curing the resin member to bond the surface acoustic wave element and the base substrate to each other.

7. The method according to claim 6, **characterized in that** the resin member is formed on the base substrate by screen printing.
